# FASCICULE DE BREVET EUROPEEN

(11) **EP 3 001 450 B1**
(45) Date de publication et mention de la délivrance du brevet: **17.04.2019**
(21) Numéro de dépôt: 15184347.1
(22) Date de dépôt: 08.09.2015
(51) Int. Cl.: H01L 21/324, H01L 21/265, H01L 29/20, H01L 21/225

(54) **PROCÉDÉ D'ACTIVATION DE DOPANTS DE TYPE P DANS UNE COUCHE SEMI-CONDUCTRICE À BASE DE GAN**
VERFAHREN ZUR AKTIVIERUNG VON P-DOTIERSTOFFEN IN EINER HALBLEITERSCHICHT AUF GAN-BASIS
METHOD FOR ACTIVATING P-TYPE DOPANTS IN A GAN SEMICONDUCTOR LAYER

(30) Priorité: 26.09.2014 FR 1459126
(43) Date de publication de la demande: 30.03.2016
(73) Titulaire: Commissariat à l'Energie Atomique et aux Energies Alternatives, 75015 Paris (FR)
(72) Inventeur: Agraffeil, Claire, 38000 Grenoble (FR)
(74) Mandataire: Talbot, Alexandre

(56) Documents cités:
- US-A1- 2007 269 968
- US-A1- 2010 133 656
- US-A1- 2010 147 835
- CAYREL F ET AL: "Si implanted reactivation in GaN grown on sapphire using AlN and oxide cap layers", NUCLEAR INSTRUMENTS & METHODS IN PHYSICS RESEARCH, SECTION - B:BEAM INTERACTIONS WITH MATERIALS AND ATOMS, vol. 272, 2 février 2011 (2011-02-02), pages 137-140, XP028354829, ISSN: 0168-583X, DOI: 10.1016/J.NIMB.2011.01.050 [extrait le 2011-02-02]
- LORENZ K ET AL: "High-temperature annealing and optical activation of Eu-implanted GaN", APPLIED PHYSICS LETTERS, AMERICAN INSTITUTE OF PHYSICS, US, vol. 85, no. 14, 1 janvier 2004 (2004-01-01), pages 2712-2714, XP012062749, ISSN: 0003-6951, DOI: 10.1063/1.1801686

## Description

### Domaine technique de l'invention

L'invention est relative à un procédé d'activation de dopants dans une couche semi-conductrice.

### État de la technique

L'implantation ionique est couramment utilisée pour doper des semi-conducteurs. Les ions utilisés pour le dopage sont généralement produits à partir d'une source gazeuse ou solide et impactent le semi-conducteur après avoir été accélérés, par exemple, à une énergie comprise entre 10 et 500 keV.

Une fois l'implantation terminée, le semi-conducteur dopé subit un traitement thermique destiné d'une part à restaurer la qualité cristalline du semi-conducteur, et d'autre part à activer les dopants, c'est-à-dire leur permettre de se substituer à certains atomes du réseau cristallin semi-conducteur. Le budget thermique appliqué entraine également leur diffusion dans le semi-conducteur.

Par exemple, pour obtenir un taux d'activation élevé d'ions Si⁺ (dopage n) ou d'ions Mg⁺ (dopage p) dans une couche semi-conductrice de GaN, une solution peut être de réaliser un traitement thermique du matériau sans le recouvrir d'une couche de protection. Le traitement thermique peut par exemple être réalisé à une température supérieure à 1000°C, à une pression supérieure à 15 kbar, et sous atmosphère contrôlée en azote. Cependant la réalisation d'un recuit à une pression aussi élevée n'est possible que si un dispositif adapté est disponible ce qui limite l'intérêt d'un tel procédé.

Si le traitement thermique n'est pas réalisé à haute pression, la surface du semi-conducteur peut alors être altérée. Par exemple, le GaN est un semi-conducteur dont la surface peut être dégradée lorsque la température du recuit est supérieure à 850°C et lorsque le recuit est réalisé à pression atmosphérique. Des fissures ou des trous peuvent apparaître à la surface du matériau semi-conducteur.

Pour empêcher la détérioration des semi-conducteurs, une couche de protection (« cap-layer » en anglais) peut être déposée au dessus du semi-conducteur avant ou après l'implantation ionique, et avant de réaliser le traitement thermique. La couche de protection permet de recuire le semi-conducteur à une température plus élevée que celle qu'il pourrait supporter sans appliquer une pression élevée telle que 15kbar. Le semi-conducteur dopé comporte alors moins de défauts.

Le document « Si implanted réactivation in GaN grown on sapphire using AlN and oxide cap layers » (F. Cayrel et al., Nuclear Instruments and Methods in Physics Research B, 272 (2012) 137-140) compare l'efficacité d'une couche de protection de SiO₂ et d'une couche de protection d'AlN déposée sur une couche semi-conductrice de GaN. Grâce à l'une ou l'autre des couches de protection, des recuits d'une durée de 30 secondes à 8 heures à des températures comprises entre 1000 et 1150°C sont possibles. La rugosité de surface de la couche de GaN est plus faible lorsque la couche de protection est une couche de SiO₂. En revanche, la résistance de contact spécifique est meilleure lorsque la couche de protection est une couche d'AlN, ce qui signifie que l'activation électrique des dopants est plus élevée avec la couche d'AlN qu'avec la couche de SiO₂.

Le document « Activation of ion implanted Si in GaN using a dual AlN annealing cap » (C.E. Hager et al., J Appl. Phys. 105, 033713, (2009)) montre l'intérêt de deux couches d'AlN superposées pour le dopage de type n d'un semi-conducteur de GaN. Ici, l'empilement comporte :
- une première couche d'une épaisseur de l'ordre de 80 nm, déposée par un dépôt chimique en phase vapeur aux organométalliques (« Metalorganic Chemical Vapor Déposition » ou « MOCVD » en anglais), à la même température que la température de croissance du semi-conducteur, et agissant comme une couche d'adhérence étant donné que les coefficients d'expansion thermique du GaN et du AlN sont du même ordre de grandeur ;
- une seconde couche d'AlN d'une épaisseur de l'ordre de 1 µm, déposée par pulvérisation cathodique au dessus de la première couche, ayant pour but de renforcer la protection conférée par la première couche.

Grâce à ces deux couches, il est possible de recuire le semi-conducteur à des températures pouvant aller jusqu'à 1250°C pendant 30 minutes. Cela permet d'obtenir un taux d'activation électrique des atomes de l'ordre de 70%, tout en limitant la dégradation de la surface du semi-conducteur de GaN.

Le document US 2010/0147835 A1 divulgue un procédé d'activation thermique de dopants pour une couche épitaxiale de GaN recouverte d'un bloc de protection de MgO.

### Objet de l'invention

On constate qu'il existe un besoin de prévoir un procédé d'activation de dopants de type p dans un semi-conducteur à base de GaN permettant d'obtenir un taux d'activation élevé tout en évitant une détérioration de la surface de la couche semi-conductrice.

On tend à résoudre ce problème au moyen d'un procédé qui comporte les étapes suivantes :
- prévoir un substrat comportant :
   ∘ une couche en matériau semi-conducteur à base de GaN muni d'impuretés dopantes électriques de type p,
   ∘ un bloc de protection comportant une couche de Mg ou MgO et dépourvu de composé à base de silicium, en contact avec la couche en matériau semi-conducteur,
   ∘ une couche de couverture à base de silicium recouvrant le bloc de protection,
- réaliser un traitement thermique à une température supérieure à 850°C de manière à activer les impuretés dopantes électriques de type p dans la couche en matériau semi-conducteur.

Le bloc de protection de Mg ou MgO peut comprendre une épaisseur comprise entre 1 et 30 nm, préférentiellement entre 1 et 15nm, idéalement entre 4 et 5 nm.

Il peut comprendre en outre une couche d'AlGaN positionnée entre la couche en matériau semi-conducteur et la couche en Mg ou MgO, la couche d'AlGaN ayant une d'épaisseur comprise entre 1 et 40 nm, préférentiellement entre 5 et 20 nm. La couche d'AlGaN peut alors comporter jusqu'à 50% de Ga, avantageusement jusqu'à 20% de Ga, et préférentiellement moins de 5% de Ga. Selon une alternative, la couche d'AlGaN peut être complètement dépourvue de Ga.

Selon un mode de réalisation particulier, le bloc de protection peut également comporter une couche supplémentaire d'AlN ou d'AlGaN, d'épaisseur comprise entre 1 et 40 nm, préférentiellement entre 5 et 20 nm, positionnée entre la couche de Mg ou MgO et la couche de couverture.

Selon un aspect de l'invention, le dépôt de la couche de couverture peut être réalisé à une température inférieure à 850°C, préférentiellement comprise entre 700 et 800°C. Le matériau de la couche de couverture peut être choisi parmi le silicium, l'oxyde de silicium, ou le nitrure de silicium. L'épaisseur de la couche de couverture peut être comprise entre 5 et 500 nm, préférentiellement entre 50 et 150nm, et idéalement égale à 100 nm.

Par ailleurs, l'implantation des ions dopants peut être réalisée à une température comprise entre 15°C et 700°C :
- avant le dépôt du bloc de protection, ou
- après le dépôt du bloc de protection et avant le dépôt de la couche de couverture, ou
- après le dépôt de la couche de couverture.

En ce qui concerne le traitement thermique, celui-ci peut être réalisé sous une atmosphère comportant un gaz choisi, par exemple, parmi N₂, NF₃, NH₃, Ar He, ou des mélanges de N₂/H₂ ou de Ar/H₂. Il peut comporter au moins un recuit réalisé à une température supérieure à 1000°C.

L'étape de traitement thermique peut par ailleurs être réalisée à une pression comprise entre 1 bar et 15 kbar, avantageusement entre 1 bar et 1kbar, et préférentiellement entre 1 et 10 bars, et idéalement à 1 bar.

Enfin, l'épaisseur de la couche en matériau semi-conducteur peut être comprise entre 5nm et 10*µ*m, préférentiellement 500nm et 10*µ*m, avantageusement égale à 1*µ*m.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1 illustre un substrat doté d'une couche en matériau semi-conducteur,
- la figure 2 illustre une phase d'implantation d'impuretés dopantes électriques,
- la figure 3 à 7 illustrent quatre configurations possibles d'un substrat recouvert d'un bloc de protection,
- la figure 8 présente un substrat recouvert d'un bloc de protection et d'une couche de couverture,
- la figure 9 illustre l'étape de traitement thermique destinée à activer les impuretés dopantes électriques,
- les figures 10 et 11 illustrent des étapes de gravure destinées à retirer la couche de couverture et le bloc de protection du substrat,
- la figure 12 représente le substrat muni d'une couche en matériau semi-conducteur doté d'impuretés dopantes électriques activées,
- les figures 13 à 15 représentent schématiquement les profils de concentration de dopants de type p dans un substrat à base de GaN lorsque ce dernier est recouvert d'un bloc de protection, d'une couche de couverture, ou d'un bloc de protection et d'une couche de couverture.

### Description détaillée

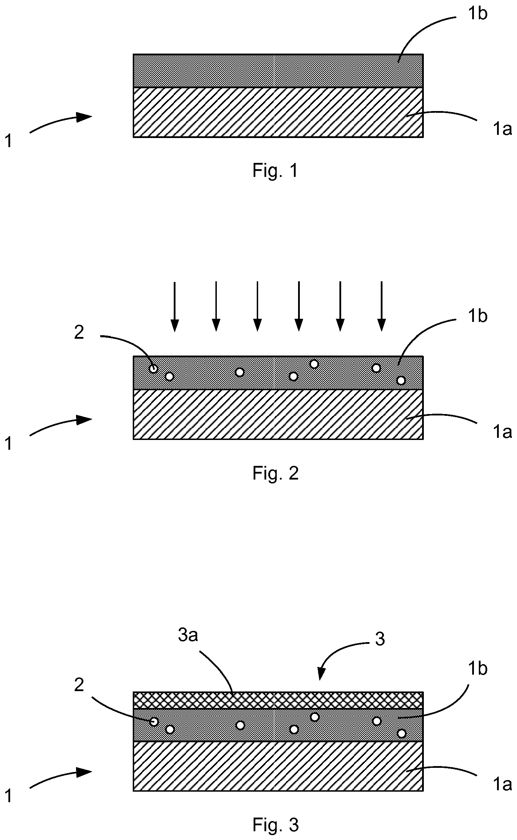

Selon un mode de mise en oeuvre du procédé d'activation de dopants représenté sur les figures 1 à 12, il faut tout d'abord prévoir un substrat 1 comportant avantageusement un support 1a par exemple en silicium, en sapphire, Al₂O₃ ,SiC, et une couche en matériau semi-conducteur 1b à base de GaN (cf. figure 1). En alternative, le substrat 1 peut être en GaN massif.

Lorsque le substrat 1 est un bloc de GaN massif, il est possible de recouvrir la face arrière de couches de protection avantageusement identiques à celles déposées sur le substrat 1 en face avant, et qui vont être décrites ci-après. La face avant du substrat 1 est définie ici comme la face impactée par le faisceau d'impuretés dopantes, et la face arrière comme la face opposée à la face avant.

La réalisation du substrat 1 peut comprendre une première étape de nettoyage du support 1a, comme par exemple un nettoyage de type RCA si le support 1a est en silicium.

La couche en matériau semi-conducteur 1b est ensuite fabriquée par croissance épitaxiale directement sur le support 1a. Le matériau du support 1a doit être judicieusement choisi pour avoir des paramètres de maille similaires à ceux de la couche en matériau semi-conducteur 1b afin que cette dernière croisse de manière cohérente. Pour améliorer la qualité de la couche en matériau semi-conducteur 1b, une couche intermédiaire à base d'AlGaN peut éventuellement être déposée sur le support 1a avant la croissance épitaxiale de la couche 1b (mode de réalisation non représenté).

Lorsque la réalisation de la couche en matériau semi-conducteur 1b est terminée, celle-ci peut avoir une épaisseur comprise entre 5nm et 10*µ*m, avantageusement entre 5nm et 10*µ*m, préférentiellement 500nm et 10*µ*m, idéalement égale à 1*µ*m.

Le substrat 1 est destiné à être recuit à une température élevée, par exemple supérieure à 850°C afin d'activer des espèces dopantes 2 après implantation. Or, au-delà d'une température de l'ordre de 850°C, la couche en matériau semi-conducteur 1b à base de GaN est fortement dégradée. Des couches de protection sont donc utilisées afin de réaliser le traitement thermique du substrat 1 à une température élevée tout en limitant fortement la dégradation de la surface de la couche semi-conductrice 1b.

A cet effet, un bloc de protection 3 dépourvu de tout composé à base de silicium est déposé sur le substrat 1. Sa nature dépend du type de dopage souhaité pour la couche semi-conductrice 1b.

Lorsque, dans un exemple non revendiqué, le dopage recherché de la couche en matériau semi-conducteur 1b est un dopage de type n, le bloc de protection 3 est préférentiellement formé d'une unique couche d'AlGaN 3a (cf. figure 3). L'un des rôles de l'AlGaN est de permettre le recuit de la couche semi-conductrice 1b tout en limitant la dégradation de la surface du matériau et en la rendant la moins résistive possible.

L'AlGaN est un matériau judicieusement choisi car ses paramètres de maille sont très proches de ceux du matériau semi-conducteur à base de nitrure de gallium, ce qui permet d'augmenter l'adhérence du bloc de protection 3 sur le substrat 1.

L'AlGaN permet également de réaliser une couche en matériau semi-conducteur 1b ayant non seulement une bonne qualité électrique, mais aussi un état de surface amélioré et qui soit moins résistif que dans l'art antérieur. La couche d'AlGaN 3a peut comprendre jusqu'à 50% de Ga, avantageusement moins de 20% de Ga et préférentiellement moins de 5% de Ga (en pourcentages atomiques). Dans un cas particulier, la couche d'AlGaN peut être complètement dépourvue de Ga et donc être une couche d'AIN.

La couche d'AlGaN 3a peut par exemple être déposée par MOCVD dans un équipement identique à celui ayant servi pour la croissance épitaxiale de la couche en matériau semi-conducteur 1b. Le dépôt peut être réalisé à la température de nucléation du matériau semi-conducteur ou à une température inférieure, de l'ordre de 500°C par exemple. Il est avantageux de déposer la couche 1b et la couche 3a dans le même équipement sans que le substrat ne soit mis au contact de l'air.

Dans une alternative, qui ne fait pas partie de l'invention, dans le cas d'un dopage de type n, le bloc de protection 3 peut être une couche unique d'AlN 3a. Celle-ci peut être réalisée par MOCVD, par Dépôt Physique en phase Vapeur (« Physical Vapor Déposition » ou PVD en anglais) ou tout autre technique de dépôt du domaine de la microélectronique permettant de déposer ce type de couche.

La couche 3a a avantageusement une épaisseur comprise entre 1 et 40 nm, plus préférentiellement entre 5 et 20nm, et idéalement égale à 10 nm. Cette épaisseur est suffisante pour créer une barrière efficace afin d'empêcher l'évaporation des molécules d'azote de la couche en matériau semi-conducteur 1b lors du recuit. Une épaisseur de 10nm est suffisante pour éviter la dégradation de la couche 3a lors du traitement thermique, pouvant aller jusqu'à des fissures privant la couche semi-conductrice de barrière de protection. Cette épaisseur est également suffisamment faible pour être éliminée sans difficulté à l'issue du processus de dopage.

Dans un cas, qui est revendiqué, où un dopage de type p est recherché, un bloc de protection 3 comprenant une couche d'AlGaN et une couche de Mg ou MgO peut être déposé sur le substrat 1. Selon les modes de réalisation, la couche de Mg ou MgO peut séparer la couche de AlGaN et la couche en matériau semi-conducteur 1b. Il est également possible de prévoir que la couche de Mg ou MgO est séparée de la couche en matériau semi-conducteur 1b par la couche d'AlGaN.

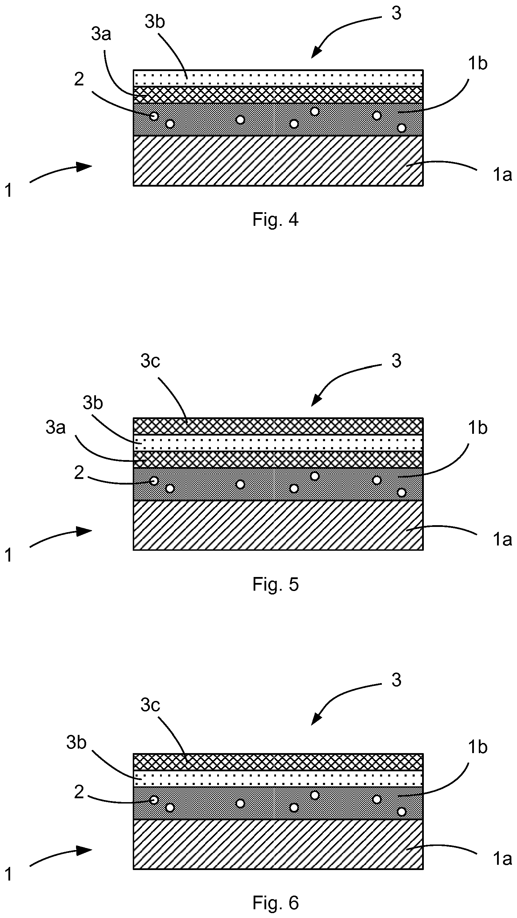

Selon un premier mode de réalisation illustré à la figure 4, le bloc de protection 3 comprend une couche d'AlGaN ou d'AlN 3a en contact avec la couche en matériau semi-conducteur 1b, et une couche de Mg ou MgO 3b en contact avec la couche 3a.

La couche de Mg ou MgO agit comme réservoir d'atomes de Mg qui constituent des impuretés dopantes de type p pouvant diffuser à travers la couche d'AlGaN 3a vers la couche en matériau semi-conducteur 1b. La couche à base de AlGaN empêche également la diffusion vers la couche en matériau semi-conducteur 1b d'espèces appartenant à d'autres couches pouvant être déposées au dessus de la couche 3b.

Le dépôt de la couche d'AlGaN 3a est avantageusement réalisé selon un procédé analogue à celui qui vient d'être décrit en relation avec un dopage n. L'épaisseur de la couche d'AlGaN 3a est comprise entre 1 et 40 nm, préférentiellement entre 5 et 20 nm et idéalement égale à 10 nm. Cette gamme d'épaisseur permet d'avoir une couche 3a suffisamment faible pour autoriser la diffusion des atomes de Mg en direction de la couche 1b et suffisamment épaisseur pour assurer la fonction de barrière pour les autres espèces non désirées.

La couche de Mg ou MgO 3b a avantageusement une épaisseur comprise entre 1 et 30 nm, préférentiellement entre 1 et 15 nm, et idéalement entre 4 et 5 nm. A épaisseur égale, les inventeurs ont toutefois observé que l'utilisation d'une couche de Mg au lieu d'une couche de MgO permet de réaliser une couche en matériau semi-conducteur ayant une concentration en dopants plus importante.

La couche de Mg ou MgO 3b est déposée sur la première couche d'AlGaN ou d'AlN 3a par un canon à ions (« Ion Beam Déposition » ou IBD en anglais), par Dépôt Physique en phase Vapeur (« Physical Vapor Déposition » ou « PVD » en anglais), ou tout autre technique de dépôt connue de l'homme du métier permettant de déposer ce type de matériau Le dépôt peut par exemple être réalisé à température ambiante et à la pression atmosphérique.

La combinaison d'une couche d'AlGaN 3a et d'une couche de Mg ou MgO 3b empêche, au cours du traitement thermique, la formation d'un puits de concentration de dopants dans la couche en matériau semi-conducteur 1b et une accumulation de dopants à sa surface. La répartition des dopants en fonction de la profondeur dans le matériau semi-conducteur 1b est plus homogène qu'avec les techniques de l'art antérieur.

Dans un mode de réalisation alternatif du bloc de protection 3, une couche supplémentaire d'AlN ou d'AlGaN 3c peut être déposée sur la couche de Mg ou MgO 3b (cf. figure 5). Si la couche 3c est réalisée en AlGaN, celle-ci peut comprendre jusqu'à 50% de Ga, avantageusement moins de 20% de Ga et préférentiellement moins de 5% de Ga (en pourcentages atomiques).

Cette couche 3c peut avoir une épaisseur comprise entre 1 et 40 nm, préférentiellement entre 5 et 20 nm et idéalement égale à 10 nm. Cette épaisseur est suffisante pour que la couche 3c puisse jouer correctement son rôle de barrière de diffusion envers des espèces issues de couches déposées au dessus de la couche 3c.

Si les couches 3a et 3c sont utilisées la somme des épaisseurs des couches 3a et 3c peut avantageusement être comprise dans la gamme 10-20nm pour assurer la fonction de barrière. Il est également possible de prévoir que la somme des épaisseurs des couches 3a et 3c et de la couche de Mg ou MgO est comprise dans la gamme 14-25nm pour assurer la fonction de barrière. La croissance de la couche d'AlN 3c peut par exemple être réalisée par MOCVD, par PVD, ou par toute technique de dépôt du domaine de la microélectronique permettant de déposer ce type de matériau. La température à laquelle le dépôt est réalisé est inférieure ou égale à la température de nucléation du matériau semi-conducteur.

La couche d'AlN ou d'AlGaN 3c permet également, en association avec la couche d'AlGaN 3a de prendre en sandwich la couche de Mg ou MgO 3b, et d'assurer la bonne tenue en température du bloc de protection 3 lors des traitements thermiques d'activation des dopants 2. Cet empilement particulier permet d'avoir un bloc de protection contenant une couche de Mg ou MgO et qui présente un coefficient de dilatation thermique proche de celui de la couche 1b ce qui réduit les problèmes d'adhésion.

A titre d'exemple, dans un mode de réalisation particulièrement avantageux du bloc de protection 3, celui-ci comporte une couche d'AlGaN 3a, une couche de Mg ou MgO 3b et une couche d'AlN 3c dans laquelle la somme des épaisseurs des couches 3a et 3c est d'environ 10 nm. Les inventeurs ont en effet observé qu'une telle épaisseur d'AlGaN et/ou d'AlN empêche la formation d'un puits de concentration de Mg dans la couche en matériau semi-conducteur 1b, ainsi qu'une accumulation d'impuretés dopantes Mg à sa surface.

Selon un mode de réalisation alternatif pouvant être utilisé pour un dopage de type p, le bloc de protection 3 peut comprendre une couche de Mg ou MgO 3b déposée directement sur la couche en matériau semi-conducteur 1b, et une couche d'AlN ou d'AlGaN 3c déposée sur la couche 3b (cf. figure 6). Les techniques utilisées pour déposer la couche 3b sont similaires à celles évoquées précédemment, notamment par IBD ou PVD.

Ce mode de réalisation présente l'avantage d'être plus simple à mettre en oeuvre par rapport à la mise en place d'un bloc de protection comportant trois couche. Il faut toutefois garder à l'esprit que le retrait de la couche 3b directement déposée sur la couche en matériau semi-conducteur 1b est plus difficile que le retrait d'une couche d'AlN ou d'AlGaN.

Dans ce mode de mise en oeuvre, la couche 3b en Mg ou MgO a avantageusement une épaisseur comprise entre 1 et 30 nm, préférentiellement entre 1 et 15 nm, et idéalement entre 4 et 5 nm. La couche 3c en AlN ou AlGaN peut avoir une épaisseur comprise entre 1 et 40 nm, préférentiellement entre 5 et 20 nm et idéalement égale à 10 nm.

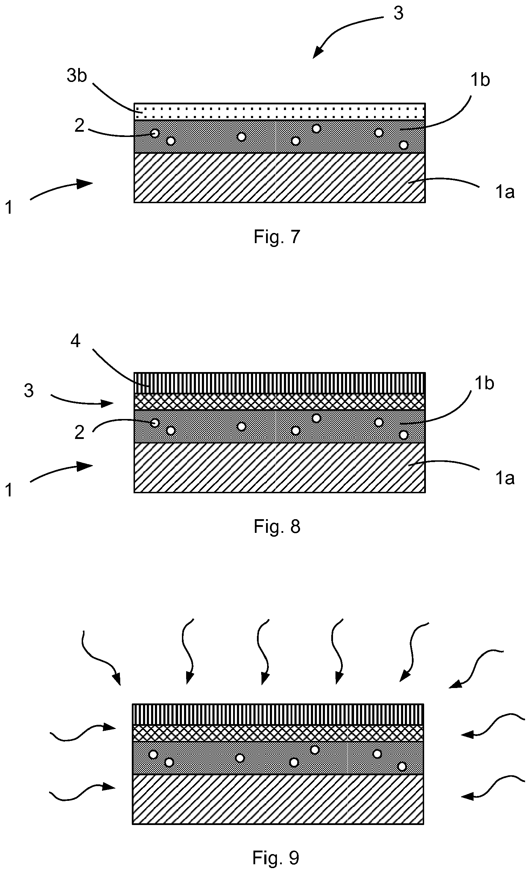

Selon un quatrième mode de réalisation du bloc de protection 3 utilisé pour le dopage p de la couche en matériau semi-conducteur 1b, le bloc de protection peut contenir une unique couche de Mg ou MgO 3b (cf. figure 7). Dans ce cas, il peut être avantageux de déposer une couche 3b ayant une épaisseur supérieure à 10nm pour que le bloc de protection 3 puisse correctement jouer son rôle de barrière de protection lors du traitement thermique.

Que le dopage réalisé soit de type n ou de type p, une couche de couverture 4 à base de silicium est déposée au dessus du bloc de protection 3. Cette étape est illustrée à la figure 8.

La couche de couverture 4 peut être en silicium amorphe, en oxyde de silicium, ou en nitrure de silicium stoechiométrique ou non et noté SiₓN_{y}. La couche 4 peut avantageusement être réalisée en SiO₂, car ce matériau est très résistant lors de changements de température.

Lorsque le procédé est utilisé pour activer des dopants de type n, ne faisant pas partie de l'invention, il n'est pas nécessaire que le bloc de protection 3 soit pourvu d'une couche de Mg ou MgO. Dans ce cas, des atomes de Si peuvent diffuser à travers le bloc de protection 3 en direction de la couche en matériau semi-conducteur 1b, ce qui renforce le dopage de type n.

Le dépôt de la couche de couverture 4 peut être réalisé à une température inférieure à 850°C, et de préférence comprise entre 700 et 800°C par LPCVD. Selon la nature du matériau de la couche 4, il est possible de réaliser un dépôt chimique en phase vapeur assisté par plasma (« Plasma Enhanced Chemical Vapor Déposition » ou « PECVD » en anglais) dans une gamme de température avantageusement comprise entre 200°C et 600°C. Le dépôt réalisé par LPCVD est toutefois préféré pour la qualité de la couche obtenue. Il est également possible d'utiliser toute autre technique de dépôt du domaine de la microélectronique permettant de déposer ce type de couche.

Dans le cas où le dépôt de la couche de couverture 4 est réalisé par LPCVD, la vitesse de croissance du matériau peut avantageusement être comprise entre 2,5 et 3,5 nm/min dans une gamme de température comprise entre 700 et 800°C. Cette gamme de valeur présente l'avantage de permettre une croissance cristalline de meilleure qualité de la couche de couverture 4, et donc une meilleure tenue en température.

Une fois le dépôt terminé, la couche de couverture 4 peut avantageusement avoir une épaisseur comprise entre 5 et 500 nm, préférentiellement entre 50 et 150 nm et idéalement égale à 100 nm. La couche de couverture 4 peut être plus épaisse que le bloc de protection 3 de sorte à permettre une bonne tenue en température de l'ensemble, et donc d'augmenter la température des traitements thermiques appliqués pour l'activation des dopants.

Pour améliorer l'adhérence de la couche de couverture 4 sur le bloc de protection 3, un nettoyage de la surface du bloc de protection 3 peut être réalisé préalablement à l'étape de dépôt de la couche de couverture 4. Le nettoyage peut être effectué par exemple par désoxydation à l'aide d'une solution d'hydroxyde d'ammonium NH₄0H et d'eau en rapport volumique (1 : 1) à une température comprise entre 60 et 70°C. De manière alternative, le nettoyage de la première couche de couverture peut être réalisé par toute autre chimie de préparation de surface adaptée au matériau.

Le bloc de protection 3 permet également de limiter les contraintes mécaniques entre le substrat 1 et la couche de couverture 4, qui ont des coefficients d'expansion thermique très différents. A titre illustratif, le nitrure de gallium a un coefficient d'expansion thermique égal à 5.6×10⁻⁶ K⁻¹ et la couche de couverture 4 peut avoir un coefficient d'expansion thermique compris entre 0.5×10⁻⁶ K⁻¹ et 3.3×10⁻⁶ K⁻¹ selon sa composition chimique. Le coefficient d'expansion thermique du bloc de protection 3 en nitrure d'aluminium est de 4.5×10⁻⁶ K⁻¹, ce qui correspond à une valeur intermédiaire entre celle du substrat 1 et celle de la couche de couverture 4. Le bloc de protection 3 fait donc office de tampon entre le substrat 1 et la couche de couverture 4 et limite les contraintes mécaniques de l'empilement des différentes couches les unes sur les autres.

Par ailleurs, les matériaux de la couche de couverture 4 ont une meilleure tenue en température que l'AlN utilisé pour réaliser le bloc de protection 3. La couche de couverture 4 protège donc le substrat 1 et le bloc de protection 3 lors de la phase de traitement thermique destinée à activer les dopants implantés dans la couche en matériau semi-conducteur 1b.

Pour doper la couche en matériau semi-conducteur 1b, une implantation peut être réalisée après le dépôt de la couche de couverture 4, ou après le dépôt du bloc de protection 3 et avant le dépôt de la couche de couverture 4. En alternative, la couche en matériau semi-conducteur 1b peut être dopée directement par épitaxie lors du dépôt MOCVD, par faisceau d'ions ou par immersion plasma avant le dépôt de la couche de protection 3. Ces techniques peuvent être mises en oeuvre seules ou en combinaison.

Lorsque le dopage souhaité de la couche en matériau semi-conducteur est de type n, ne faisant pas partie de l'invention, des ions Si⁺ peuvent être implantés dans la couche 1b. De manière alternative, il est envisageable d'implanter d'autres espèces (ions ou neutres) telles que Be, Ge, O à la place des impuretés de type Si.

Pour réaliser un dopage de type p, des ions Mg⁺ peuvent être implantés dans la couche en matériau semi-conducteur 1b. Il est également possible de prévoir une co-implantation Mg⁺/P⁺ ou co-implantation Mg⁺/N⁺ dans la couche en matériau semi-conducteur 1b. Une autre option peut être d'implanter d'autres espèces (ions ou neutres) telles que Ca, Zn ou C.

De manière classique, les conditions d'implantation sont imposées d'une part par les performances techniques des équipements d'implantation, et d'autre part par la concentration et la localisation des impuretés dopantes électriques 2 que l'on souhaite implanter dans la couche en matériau semi-conducteur 1b. Par exemple, pour un faisceau d'ions Mg⁺ ayant une fluence de 2.10¹⁵ atomes/cm² et une énergie de 200keV, la profondeur d'implantation dans une couche semi-conductrice de GaN qui n'est pas recouverte d'une couche de protection est de l'ordre de 400 nm.

Dans le cadre de l'invention, l'implantation ionique peut être réalisée avec une fluence comprise entre 1.10¹⁴ et 1.10¹⁶ atomes/cm², avec une énergie comprise entre 25 et 1000 keV.

Les conditions d'implantation dépendent également des conditions de température, c'est-à-dire de la température à laquelle se trouve le substrat 1. Selon un mode de mise en oeuvre, l'implantation peut être réalisée à température ambiante, ou à une température comprise entre 15°C et 700°C. L'implantation des dopants 2 à une température supérieure à la température ambiante permet de limiter la dégradation de la maille cristalline du semi-conducteur, et de la réorganiser partiellement avant de réaliser un traitement thermique de restauration. De cette façon, le traitement thermique peut être réalisé pendant une durée plus courte, et à une température moins élevée.

Le dopage de la couche en matériau semi-conducteur 1b peut être réalisé à différents stades: soit directement après le dépôt de la couche en matériau semi-conducteur 1b, ou avantageusement après le dépôt du bloc de protection 3. Une autre alternative peut être de le réaliser après le dépôt de la couche de couverture 4.

Lorsque le bloc de protection 3 comporte plusieurs couches, il est possible de réaliser l'implantation après le dépôt de l'une de ces couches, quelle qu'elle soit.

Dans ce cas, l'énergie d'implantation des impuretés dopantes électriques doit être adaptée pour passer à travers les couches du bloc de protection 3. Pour une profondeur d'implantation moyenne identique, l'énergie du faisceau d'ions doit être plus importante lorsque les impuretés sont implantées à travers le bloc de protection 3 que lorsqu'elles sont directement implantées après l'étape de croissance épitaxiale de la couche en matériau semi-conducteur 1b.

Le fait d'implanter les impuretés dopantes électriques 2 après le dépôt du bloc de protection 3 permet par exemple d'éviter un effet de canalisation au cours de l'étape d'implantation ionique. L'effet de canalisation peut conduire à une couche en matériau semi-conducteur 1b dont les impuretés dopantes électriques 2 sont implantées profondément et ne sont pas réparties de manière homogène.

Selon une troisième alternative de mise en oeuvre, il est possible de réaliser l'implantation après avoir déposé le bloc de protection 3 et la couche de couverture 4.

Dans ce cas, l'énergie d'implantation des impuretés dopantes électriques 2 dans la couche en matériau semi-conducteur 2 doit être encore plus élevée que dans les modes de mise en oeuvre décrits précédemment afin que les impuretés dopantes électriques 2 puissent traverser le bloc de protection 3 et la couche de couverture 4.

Une fois l'étape d'implantation effectuée, l'activation des dopants est réalisée par traitement thermique (cf. figure 9). La nature des matériaux de la couche de couverture 4 permet d'effectuer des recuits rapides (« Rapid Thermal Annealing » ou « RTA » et « Rapid Thermal Processing » ou « RTP » en anglais) pour que le taux d'activation des impuretés dopantes électriques 2 soit élevé sans que la surface de la couche semi-conductrice 1b soit endommagée.

Des recuits standards (« Furnace Annealing » en anglais) peuvent également être réalisés pour permettre une diffusion efficace des impuretés dopantes électriques 2 dans la couche semi-conductrice 1b. Ce type de traitement thermique est particulièrement opportun dans le cas d'un dopage de type p, car il favorise la diffusion des dopants Mg de la couche 3b à travers 3a vers la couche en matériau semi-conducteur 1b.

Lors de l'étape de traitement thermique, il est donc possible de réaliser un recuit standard, un recuit rapide, ou une combinaison de différents recuits selon le résultat que l'on souhaite obtenir.

A titre illustratif, un recuit standard à une température comprise entre 850 et 1250°C peut être réalisé pendant une durée allant de quelques minutes à quelques heures. Un recuit rapide peut également être effectué dans une gamme de température allant de 850 à 1350°C pendant une durée comprise entre quelques secondes et quelques minutes. Avantageusement, le ou les recuits peuvent être réalisés sous une atmosphère contrôlée contenant un gaz choisi parmi N₂, Ar, He, ou NF₃, NH₃, ou des mélanges de N₂/H₂ ou de Ar/H₂. Il vaut mieux éviter d'avoir une atmosphère oxydante pour limiter la diffusion d'oxygène dans la matrice semi-conductrice. Il est préférable d'utiliser une atmosphère à base ou constituée de N₂, Ar, He, NF₃.

De manière générale, le traitement thermique peut consister en un recuit standard unique, ou un recuit rapide unique, ou alors toute combinaison de recuits rapides et de recuits standards, quels que soient leur nombre et leur ordre. Il peut avantageusement comprendre au moins un recuit à une température supérieure à 1000°C pour obtenir un taux d'activation élevé des impuretés dopantes électriques 2.

Par rapport aux procédés de dopage du GaN de l'art antérieur, le fait d'associer un bloc de protection 3 à base d'AlGaN et une couche de couverture 4 à base de Si permet donc de réaliser un traitement thermique à une température plus élevée et pendant une durée plus longue.

Par ailleurs, la mise en oeuvre d'un traitement thermique standard permet de réaliser une répartition optimale des impuretés dopantes électriques 2 par diffusion de ces dernières dans la couche semi-conductrice 1b. La mise en oeuvre d'un traitement thermique rapide à température élevée permet d'autre part d'obtenir un taux d'activation élevé des impuretés dopantes électriques 2. Le bloc de protection 3 et la couche de couverture 4 empêchent quant à eux l'endommagement de la surface de la couche semi-conductrice 1b, la dégradation de son état de surface, et la modification de la composition chimique du matériau semi-conducteur par dégazage d'azote.

Par ailleurs, le traitement thermique est réalisée sous une pression comprise entre 1 et 15 kbar, avantageusement entre 1 bar et 1 kbar, et idéalement entre 1 et 10 bar.

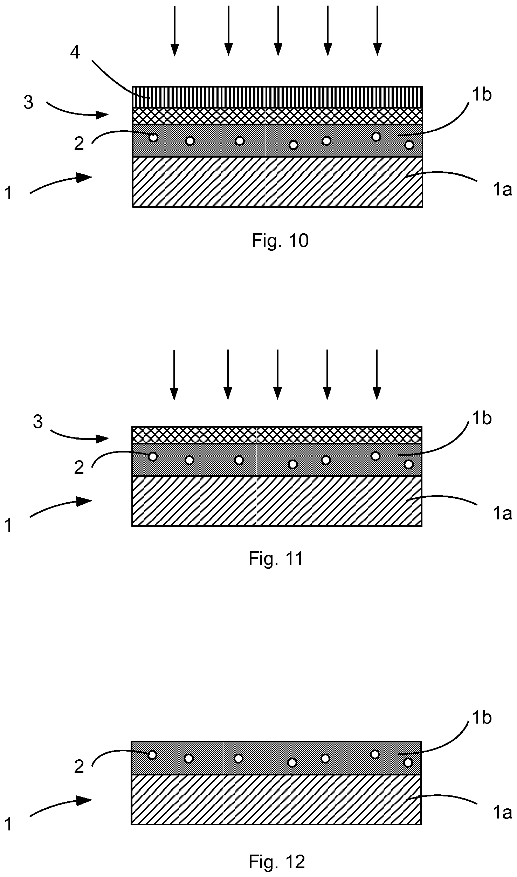

Lorsque l'étape de traitement thermique est terminée, le bloc de protection et la couche de couverture 4 doivent être retirés. Pour cela, on peut réaliser successivement une première étape de gravure pour retirer la couche de couverture 4 (cf. figure 10), puis une seconde étape de gravure pour retirer le bloc de protection 3 (cf. figure 11).

Le retrait de la couche de couverture 4 à base de silicium peut par exemple être réalisé par gravure humide au moyen d'acide fluorhydrique (HF) ou d'acide phosphorique (H₃PO₄). Le bloc de protection 3 à base d'AlN peut également être retiré par gravure humide à l'aide d'acide phosphorique ou de KOH.

De manière alternative et avantageuse, le bloc de protection 3 peut être retiré par planarisation mécano-chimique (« Chemical-Mechanical Planarization » ou « CMP » en anglais).

On obtient finalement un substrat 1 comprenant une couche en matériau semi-conducteur 1b doté d'impuretés dopantes n ou p, avec un très bon taux d'activation (cf. figure 12). Le taux d'activation des impuretés dopantes de type p est compris entre 5 et 30%, et le taux d'activation des impuretés dopantes de type n est généralement compris entre 50 et 100%.

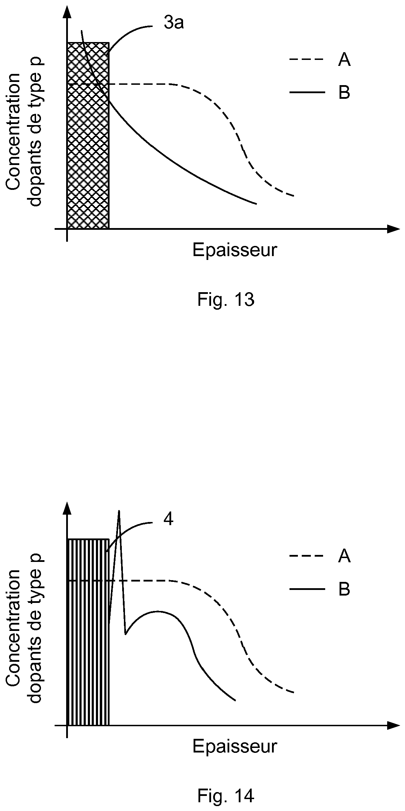

Les figures 13 à 15 illustrent schématiquement les profils de concentration de dopants de type p dans un semi-conducteur à base de GaN pour différents empilements destinés à protéger le semi-conducteur lors des recuits. L'implantation des dopants a été réalisée avant ou après le dépôt des couches de protection à base d'AlN et/ou à base de silicium, et les dopants peuvent par exemple être des atomes de Mg. Pour chaque graphe, la courbe A représente le profil de concentration des dopants avant recuit, et la courbe B le profil de concentration des dopants après un traitement thermique comportant au moins un recuit à une température supérieure à 1000°C.

Dans le schéma illustré à la figure 13, la couche semi-conductrice 1b est recouverte d'un bloc de protection 3 comportant une unique couche d'AlGaN 3a. Cette couche 3a est déposées selon l'une des techniques décrites ci-dessus, et possède les propriétés énoncées auparavant. Elle peut notamment être une couche d'AlN.

Il apparaît qu'une couche d'AlGaN seule ne constitue pas une barrière efficace lors du traitement thermique. Les dopants se sont concentrés dans la couche d'AlGaN ou ont diffusé lors du recuit.

A titre de comparaison, la figure 14 illustre le cas où la couche semi-conductrice 1b est recouverte d'une couche de couverture 4 à base de silicium telle que celle décrite ci-dessus. Cette couche peut par exemple être en un matériau du type SiOₓ, SiNₓ ou SiₓN_{y}.

La couche de couverture 4 à base silicium constitue une barrière efficace contre la diffusion à haute température des dopants lors du recuit d'activation. Toutefois, ceux-ci s'accumulent en surface, et un puits de concentration est également observé un peu plus en profondeur. La répartition des dopants n'est donc pas optimale non plus.

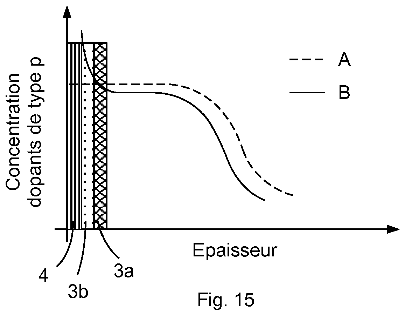

La figure 15 illustre le cas où la couche semi-conductrice 1b est recouverte successivement d'un bloc de protection 3 comportant une couche d'AlGaN 3a et une couche de Mg ou MgO 3b, et d'une couche de couverture 4 à base de silicium.

La combinaison de ces différentes couches permet non seulement d'activer une quantité beaucoup plus importante de dopants dans la matrice semi-conductrice, mais aussi d'avoir une concentration sensiblement identique par rapport à la concentration initiale implantée, sur une épaisseur importante de la couche de GaN. Cet empilement constitue une barrière efficace contre la diffusion à haute température des dopants, et permet également d'éviter le pic et le puits de concentration que l'on obtient si le semi-conducteur est recouvert d'une unique couche à base de silicium. Des atomes de Mg peuvent également diffuser à travers la couche d'AlGaN lors du recuit, de façon à augmenter la quantité de dopants présents dans la matrice de GaN.

L'invention ne se limite pas aux caractéristiques qui viennent d'être décrites. L'homme du métier peut, sans sortir du cadre de l'invention, déposer les différentes couches de matériau sur le substrat par toute technique alternative telle que la pulvérisation PVD, le MOCVD, LPCVD, PECVD, etc.

Au lieu de réaliser une implantation ionique dans la couche en matériau semi-conducteur 1b, l'homme du métier peut, sans sortir du cadre de l'invention, doper cette couche semi-conductrice par épitaxie lors de son dépôt.

L'homme du métier peut également envisager de réaliser un dopage p dans certaines zones de la couche en matériau semi-conducteur à base de GaN, et un dopage n dans des zones différentes. Il peut également doper la couche en matériau semi-conducteur dans certaines zones et de pas réaliser de dopage dans d'autres zones de la couche. A cet effet, un masque peut être utilisé pour protéger certaines zones du substrat lors de l'implantation ionique.

La formation de structures en GaN dopé n ou p est particulièrement utile à la réalisation de transistors à haute mobilité électronique, diodes Schottky et de composants optoélectroniques tels que les LED.

## Revendications

1. Procédé d'activation de dopants de type p dans un semi-conducteur à base de GaN comportant les étapes suivantes :
• prévoir un substrat (1) comportant :
∘ une couche en matériau semi-conducteur (1b) à base de GaN muni d'impuretés dopantes électriques de type p (2),
∘ un bloc de protection (3) comportant une couche de Mg ou MgO (3b) et dépourvu de composé à base de silicium, en contact avec la couche en matériau semi-conducteur (1b),
∘ une couche de couverture (4) à base de silicium recouvrant le bloc de protection (3),
• réaliser un traitement thermique à une température supérieure à 850°C de manière à activer les impuretés dopantes électriques (2) dans la couche en matériau semi-conducteur (1b).

2. Procédé d'activation de dopants selon la revendication 1, dans lequel la couche de Mg ou MgO (3b) a une épaisseur comprise entre 1 et 30 nm, préférentiellement entre 1 et 15 nm, et idéalement entre 4 et 5 nm.

3. Procédé d'activation de dopants selon l'une quelconque des revendications 1 ou 2, dans lequel le bloc de protection (3) comporte en outre une couche d'AlGaN (3a) positionnée entre la couche en matériau semi-conducteur (1b) et la couche en Mg ou MgO (3b), la couche d'AlGaN (3a) ayant une d'épaisseur comprise entre 1 et 40 nm, préférentiellement entre 5 et 20 nm.

4. Procédé d'activation de dopants selon la revendication 3, dans lequel la couche d'AlGaN (3a) comporte jusqu'à 50% de Ga, avantageusement jusqu'à 20% de Ga, et préférentiellement moins de 5% de Ga.

5. Procédé d'activation de dopants selon la revendication 4, dans lequel la couche d'AlGaN (3a) est complètement dépourvue de Ga.

6. Procédé d'activation de dopants selon l'une quelconque des revendications 3 à 5, dans lequel le bloc de protection (3) comporte une couche additionnelle d'AlGaN (3c), d'épaisseur comprise entre 1 et 40 nm, préférentiellement entre 5 et 20 nm, positionnée entre la couche de Mg ou MgO (3b) et la couche de couverture (4).

7. Procédé d'activation de dopants selon l'une quelconque des revendications 1 à 6, dans lequel le dépôt de la couche de couverture (4) est réalisé à une température inférieure à 850°C, préférentiellement comprise entre 700 et 800°C.

8. Procédé d'activation de dopants selon l'une quelconque des revendications 1 à 7, dans lequel l'épaisseur de la couche de couverture (4) est comprise entre 5 et 500 nm, préférentiellement entre 50 et 150 nm, et idéalement égale à 100 nm.

9. Procédé d'activation de dopants selon l'une quelconque des revendications 1 à 8, dans lequel le bloc de protection (3) est déposé sur la couche en matériau semi-conducteur (1b), puis les impuretés dopantes électriques (2) sont implantées dans la couche en matériau semi-conducteur (1b) à travers le bloc de protection (3) avant de réaliser le traitement thermique.

10. Procédé d'activation de dopants selon l'une quelconque des revendications 1 à 9, dans lequel la couche de couverture (4) à base de silicium est déposée sur le bloc de protection (3), puis les impuretés dopantes électriques (2) sont implantées dans la couche en matériau semi-conducteur (1b) à travers le bloc de protection (3), et à travers la couche de couverture (4) avant de réaliser le traitement thermique.

11. Procédé d'activation de dopants selon l'une quelconque des revendications 9 ou 10, dans lequel l'étape d'implantation est réalisée à une température comprise entre 15 et 700°C.

12. Procédé d'activation de dopants selon l'une quelconque des revendications 1 à 11, dans lequel l'étape de traitement thermique est réalisée sous une atmosphère comportant un gaz choisi parmi N₂, NF₃, NH₃, Ar, He, ou des mélanges de N₂/H₂ ou de Ar/H₂.

13. Procédé d'activation de dopants selon l'une quelconque des revendications 1 à 12, dans lequel l'étape de traitement thermique comporte au moins un recuit réalisé à une température supérieure à 1000°C.

14. Procédé d'activation de dopants selon l'une quelconque des revendications 1 à 13, dans lequel le traitement thermique est réalisée sous une pression comprise entre 1 et 15 kbar, avantageusement entre 1 bar et 1 kbar, et idéalement entre 1 et 10 bar.

15. Procédé d'activation de dopants selon l'une quelconque des revendications 1 à 14, dans lequel l'épaisseur de la couche en matériau semi-conducteur (1b) est comprise entre 5 nm et 10 µm, préférentiellement entre 500nm et 10*µ*m, idéalement égale à 1*µ*m.

16. Procédé d'activation de dopants selon l'une quelconque des revendications 1 à 15, dans lequel la couche de couverture (4) et le bloc de protection (3) sont retirés après le traitement thermique.

## Patentansprüche

1. Verfahren zur Aktivierung von p-Dotierstoffen in einem Halbleiter auf Basis von GaN, das die folgenden Verfahrensschritte umfasst:
• Vorsehen eines Substrats (1), das enthält:
- eine Schicht aus Halbleiter-Material (1b) auf Basis von GaN, das mit elektrischen p-Dotierstoffen (2) angereichert ist,
- einen Schutzblock (3), der eine Schicht aus Mg oder MgO (3b) enthält und keine Verbindung auf Siliziumbasis enthält, in Kontakt mit der Schicht aus Halbleiter-Material (1b),
- eine Deckschicht (4) auf Siliziumbasis, die den Schutzblock (3) bedeckt,
• Ausführen einer Wärmebehandlung bei einer Temperatur von mehr als 850 °C dergestalt, dass die elektrischen p-Dotierstoffe (2) in der Schicht aus Halbleiter-Material (1b) aktiviert werden.

2. Verfahren zur Aktivierung von Dotierstoffen nach Anspruch 1, wobei die Mg- oder MgO-Schicht (3b) eine Stärke von 1 bis 30 nm, vorzugsweise von 1 bis 15 nm, und idealerweise von 4 bis 5 nm hat.

3. Verfahren zur Aktivierung von Dotierstoffen nach einem der Ansprüche 1 oder 2, wobei der Schutzblock (3) ferner eine Schicht aus AlGaN (3a) enthält, die zwischen der Schicht aus Halbleiter-Material (1b) und der Mg- oder MgO-Schicht (3b) angeordnet ist, wobei die Schicht aus AlGaN (3a) eine Stärke von 1 bis 40 nm, vorzugsweise von 5 bis 20 nm hat.

4. Verfahren zur Aktivierung von Dotierstoffen nach Anspruch 3, wobei die Schicht aus AlGaN (3a) bis zu 50% Ga, vorteilhafterweise bis zu 20% Ga und vorzugsweise weniger als 5% Ga enthält.

5. Verfahren zur Aktivierung von Dotierstoffen nach Anspruch 4, wobei die Schicht aus AlGaN (3a) gar kein Ga enthält.

6. Verfahren zur Aktivierung von Dotierstoffen nach einem der Ansprüche 3 bis 5, wobei der Schutzblock (3) eine zusätzliche Schicht aus AlGaN (3c) mit einer Stärke von 1 bis 40 nm, vorzugsweise 5 bis 20 nm, enthält, die zwischen der Mg- oder MgO-Schicht (3b) und der Deckschicht (4) angeordnet ist.

7. Verfahren zur Aktivierung von Dotierstoffen nach einem der Ansprüche 1 bis 6, wobei das Aufbringen der Deckschicht (4) bei einer Temperatur von weniger als 850 °C, vorzugsweise von 700 bis 800 °C ausgeführt wird.

8. Verfahren zur Aktivierung von Dotierstoffen nach einem der Ansprüche 1 bis 7, wobei die Stärke der Deckschicht (4) 5 bis 500 nm, vorzugsweise 50 bis 150 nm und idealerweise 100 nm beträgt.

9. Verfahren zur Aktivierung von Dotierstoffen nach einem der Ansprüche 1 bis 8, wobei der Schutzblock (3) auf der Schicht aus Halbleiter-Material (1b) aufgebracht wird, sodann die elektrischen p-Dotierstoffe (2) durch den Schutzblock (3) hindurch in die Schicht aus Halbleiter-Material (1b) implantiert werden, bevor die Wärmebehandlung durchgeführt wird.

10. Verfahren zur Aktivierung von Dotierstoffen nach einem der Ansprüche 1 bis 9, wobei die Deckschicht (4) auf Siliziumbasis auf den Schutzblock (3) aufgebracht wird, sodann die elektrischen p-Dotierstoffe (2) durch den Schutzblock (3) und durch die Deckschicht (4) hindurch in die Schicht aus Halbleiter-Material (1b) implantiert werden, bevor die Wärmebehandlung durchgeführt wird.

11. Verfahren nach einem der Ansprüche 9 oder 10, wobei der Verfahrensschritt der Implantation bei einer Temperatur von 15 bis 700 °C ausgeführt wird.

12. Verfahren zur Aktivierung von Dotierstoffen nach einem der Ansprüche 1 bis 11, wobei der Verfahrensschritt der Wärmebehandlung in einer Atmosphäre durchgeführt wird, die ein Gas enthält, das unter N₂, NF₂, NH₃, Ar, He oder N₂/H₂- oder Ar/H₂-Gemischen gewählt wird.

13. Verfahren zur Aktivierung von Dotierstoffen nach einem der Ansprüche 1 bis 12, wobei der Verfahrensschritt der Wärmebehandlung mindestens ein Glühen umfasst, das bei einer Temperatur von mehr als 1000 °C ausgeführt wird.

14. Verfahren zur Aktivierung von Dotierstoffen nach einem der Ansprüche 1 bis 13, wobei die Wärmebehandlung unter einem Druck von 1 bis 15 kBar, vorteilhafterweise von 1 Bar bis 1 kBar und idealerweise von 1 bis 10 Bar ausgeführt wird.

15. Verfahren zur Aktivierung von Dotierstoffen nach einem der Ansprüche 1 bis 14, wobei die Stärke der Schicht aus Halbleiter-Material (1b) 5 nm bis 10 µm, vorzugsweise 500 nm bis 10 µm und idealerweise 1 µm beträgt.

16. Verfahren zur Aktivierung von Dotierstoffen nach einem der Ansprüche 1 bis 15, wobei die Deckschicht (4) und der Schutzblock (3) nach der Wärmebehandlung entfernt werden.

## Claims

1. A method activating p-type dopants in a GaN-base semiconductor comprising the following steps:
• providing a substrate (1) comprising:
∘ a semiconductor material layer (1b) made from GaN-base material provided with p-type electric dopant impurities (2),
∘ a cap block (3) comprising a Mg or MgO layer (3b) and devoid of any silicon-base compound, in contact with the semiconductor material layer (1b),
∘ a silicon-base covering layer (4) covering the protective cap block (3),
• performing heat treatment at a temperature of more than 850°C so as to activate the electric dopant impurities (2) in the semiconductor material layer (1b).

2. Method for activating dopants according to claim 1, wherein the Mg or MgO layer (3b) with a thickness comprised between 1 and 30nm, preferentially between 1 and 15nm, and ideally between 4 and 5nm.

3. Method for activating dopants according to anyone of claims 1 or 2, wherein the cap block (3) further comprises an AlGaN layer (3a) positioned between the semiconductor material layer (1b) and the Mg or MgO layer (3b), the AlGaN layer (3a) having a thickness comprised between 1 and 40nm, preferentially between 5 and 20nm.

4. Method for activating dopants according to claim 3, wherein the AlGaN layer (3a) comprises up to 50% of Ga, advantageously up to 20% of Ga, and preferentially less than 5% of Ga.

5. Method for activating dopants according to claim 4, wherein the AlGaN layer (3a) is completely devoid of Ga.

6. Method for activating dopants according to any one of claims 3 to 5, wherein the cap block (3) comprises an additional AlGaN layer (3c), having a thickness comprised between 1 and 40nm, preferentially between 5 and 20nm, positioned between the Mg or MgO layer (3b) and the covering layer (4).

7. Method for activating dopants according to any one of claims 1 to 6, wherein deposition of the covering layer (4) is performed at a temperature of less than 850°C, preferentially comprised between 700 and 800°C.

8. Method for activating dopants according to any one of claims 1 to 7, wherein the thickness of the covering layer (4) is comprised between 5 and 500nm, preferentially between 50 and 150nm, and ideally equal to 100nm.

9. Method for activating dopants according to any one of claims 1 to 8, wherein the cap block (3) is deposited on the semiconductor material layer (1b), and the electric dopant impurities (2) are then implanted in the semiconductor material layer (1b) through the cap block (3) before the heat treatment is performed.

10. Method for activating dopants according to any one of claims 1 to 9, wherein the covering layer (4) is silicon-base and is deposited on the cap block (3), and the electric dopant impurities (2) are then implanted in the semiconductor material layer (1b) through the cap block (3) and through the covering layer (4) before the heat treatment is performed.

11. Method for activating dopants according to any one of claims 9 or 10, wherein the implantation step is performed at a temperature comprised between 15 and 700°C.

12. Method for activating dopants according to any one of claims 1 to 11, wherein the heat treatment step is performed in an atmosphere comprising a gas chosen from N₂, NF₃, NH₃, Ar, He, or mixtures of N₂/H₂ or of Ar/H₂.

13. Method for activating dopants according to any one of claims 1 to 12, wherein the heat treatment step comprises at least one annealing performed at a temperature of more than 1000°C.

14. Method for activating dopants according to any one of claims 1 to 13, wherein the heat treatment is performed with a pressure comprised between 1 and 15 kbar, advantageously between 1 bar and 1 kbar, and ideally between 1 and 10 bar.

15. Method for activating dopants according to any one of claims 1 to 14, wherein the thickness of the semiconductor material layer (1b) is comprised between 5nm and 10µm, preferentially between 500nm and 10*µ*m, ideally equal to 1*µ*m.

16. Method for activating dopants according to any one of claims 1 to 15, wherein the covering layer (4) and the cap block (3) are removed after the heat treatment.
